(19)

Europäisches
Patentamt
European
Patent Office
Office européen
des brevets

(11)     **EP 3 876 234 A1**

(12)     **EUROPEAN PATENT APPLICATION**

(43) Date of publication:
**08.09.2021   Bulletin 2021/36**

(51) Int Cl.:
**G11C 11/16** *(2006.01)*       **G11C 19/08** *(2006.01)*

(21) Application number: **20161352.8**

(22) Date of filing: **06.03.2020**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **PAUL SCHERRER INSTITUT
5232 Villigen PSI (CH)**

(72) Inventors:
 • **LOU, Zhaochu
  5312 Döttingen (CH)**

 • **HRABEC, Ales
  5400 Baden (CH)**
 • **HEYDERMAN, Laura J.
  4800 Zofingen (CH)**
 • **GAMBARDELLA, Pietro
  8044 Zürich (CH)**
 • **DAO, Trong Phuong
  Cambridge, CB31A1 (GB)**

(74) Representative: **Fischer, Michael
  Siemens AG
  Postfach 22 16 34
  80506 München (DE)**

(54)     **CURRENT-DRIVEN MAGNETIC DOMAIN WALL LOGIC**

(57)     Spin-based logic architectures provide nonvolatile data retention, near-zero leakage, and scalability, extending the technology roadmap beyond complementary metal-oxide-semiconductor (CMOS) logic. Architectures based on magnetic domain-walls take advantage of fast domain-wall motion, high density, nonvolatility, and flexible design in order to process and store information. Such schemes, however, rely on domain-wall manipulation and clocking using an external magnetic field, which limits their implementation in dense, large scale chips.

The present invention discloses a concept to perform all-electric logic operations and cascading in domain-wall racetracks. The present invention exploits the chiral coupling between neighbouring magnetic domains induced by the interfacial Dzyaloshinskii-Moriya interaction to realize a domain-wall inverter, the essential basic building block in all implementations of Boolean logic. The present invention also discloses reconfigurable NAND and NOR logic gates and perform operations with current-induced domain-wall motion. Finally, several NAND gates are cascaded to build XOR and full adder gates, demonstrating electrical control of magnetic data and device interconnection in logic circuits. The present invention provides a viable platform for scalable all-electric magnetic logic, paving the way for memory-in-logic applications.

FIG 1A

FIG 1B

$H_{SOT}$   $V_{DW}$

J

$H_{SOT}$   $V_{DW}$

J

FIG 1C

10   DW   2   20   14   12

AlO$_X$      Al      AlO$_X$   8

18          Co   6   16

j   Pt   j

RT   4   22

A

**Description**

The present invention relates to a device for storing and/or processing data. Further, the present invention relates to a logical gate that comprises a number of the afore-mentioned devices.

Zhaochu Luo et al., Chirally coupled nanomagnets, Science 363, 1435 to 1439 (2019), disclose magnetically coupled nanomagnets that have multiple applications in nonvolatile memories, logic gates, and sensors. A strong coupling of laterally adjacent nanomagnets can be achieved using the interfacial Dzyaloshinskii-Moriya interaction. This coupling is mediated by chiral domain walls between out-of-plane and in-plane magnetic regions and dominates the behavior of nanomagnets below a critical size. This concept is used to realize lateral exchange bias, field-free current-induced switching between multistate magnetic configurations as well as synthetic antiferromagnets, skyrmions, and artificial spin ices covering a broad range of length scales and topologies. The document provides a platform to design arrays of correlated nanomagnets and to achieve all-electric control of planar logic gates and memory devices.

In general, spin-based logic architectures provide nonvolatile data retention, near-zero leakage, and scalability, extending the technology roadmap beyond complementary metal-oxide-semiconductor (CMOS) logic. Architectures based on magnetic domain-walls take advantage of fast domain-wall motion, high density, nonvolatility, and flexible design in order to process and store information. Such schemes, however, rely on domain-wall manipulation and clocking using an external magnetic field, which limits their implementation in dense, large scale chips.

It is therefore the objective of the present invention to provide a device for storing and/or processing data that provides a viable platform for scalable all-electric magnetic logic, paving the way for memory-in-logic applications.

This objective is achieved according to the present invention by a device for storing and/or processing data using the concept of magnetic domain wall motion induced by spin-orbit torques, said device comprising:

a) a support layer of a conductive material;
b) a ferro- or ferri-magnetic layer disposed on said support layer being able to show tunable magnetic anisotropy and providing a magnetic racetrack;
c) a functional layer in terms of the tunable magnetic anisotropy disposed on said ferro- or ferri-magnetic layer, said functional layer having a first functional section and a second functional section and a third functional section between the first and the second functional section, wherein the first and the second sections of the functional layer allowing the ferro- or ferri-magnetic layer to have an OOP (out-of-plane) magnetization perpendicular to the plane of the layers and the third section of the functional layer allowing the ferro- or ferri-magnetic layer to have an IP (in-plane) magnetization parallel to the plane of the layers only; wherein:
d) an OOP magnetization perpendicular and upwards oriented represents a logical "0" and downwards oriented a logical "1" or vice versa or an IP magnetization in one direction represents a logical "0" and in the other direction a logical "1" or vice versa;
e) said logical "1" or a logical "0" can be coded in a second region of the ferro- or ferri-magnetic layer covered by the second section or in the third region of the ferro- or ferri-magnetic layer covered by the third section in response to moving a domain wall in a first region of the ferro- or ferri-magnetic layer being covered by the first section along the magnetic racetrack (RT) towards the interface given at the transition of the first section to the third section and/or vice versa; and
f) a current supply to the support layer wherein controlled current pulses applied to the support layer causing the magnetic domain wall to determinably move along the magnetic racetrack.

Therefore, the present invention discloses a concept to perform all-electric logic operations and cascading in magnetic domain-wall racetracks. The present invention exploits the chiral coupling between neighbouring magnetic domains induced by the interfacial Dzyaloshinskii-Moriya interaction to realize a domain-wall inverter, the essential basic building block in all implementations of Boolean logic.

Preferred embodiments of the present invention can be achieved with respect to the implementation of the tunable magnetic anisotropy in the ferro- or ferri-magnetic layer when the functionality of at least one of the first, second and third section of the functional layer is achieved by at least one of:

a) the functional layer of the first and the second section is metal-oxidic layer, while the third section is a metallic layer;
b) the third section is an insulator layer comprising an electrode enabling the application of an electrical field over the ferro- or ferrimagnetic layer in the OOP direction;
c) the third section of the functional layer are metal-oxidic layer being penetrated by a solid-state proton pump and/or ion irradiation; and/or
d) the third section of the functional layer are metal-oxidic layer being penetrated by helium and/or gallium focused ion beams.

Further preferred embodiments of the device are defined by the other depending claims.

The objective with respect to the realization of a logic gate is achieved according to the present invention by a logical gate comprising a number of devices according to any of the preceding claims, wherein two magnetic racetracks representing the logical inputs of the logical gate are substantially radially, preferably in a V- or Y-shape, disposed in order to share a common second region of the ferro- or ferri-magnetic layer - said second region thereby representing the logical output of the logical gate - and to share the second functional section of the functional layer, wherein the first regions of the two magnetic racetracks are separated by a magnetic bias region of determinable magnetization and wherein the third regions of the functional layers are arranged in a ring segment shaped form in alignment with the radial arrangement, preferably the V- or Y-shaped arrangement, of the two magnetic racetracks.

Therefore, the present invention also discloses reconfigurable NAND and NOR logic gates and perform operations with current-induced domain-wall motion. Thus, several NAND gates can be cascaded to build XOR and full adder gates, demonstrating electrical control of magnetic data and device interconnection in logic circuits. The present invention provides a viable platform for scalable all-electric magnetic logic, paving the way for memory-in-logic applications.

Preferred embodiments of the logical gate are given by the other depending claims.

Preferred embodiments of the present invention are hereinafter described in more detail with reference to the attached drawings which depict in:

Fig. 1      the Chiral coupling between adjacent nanomagnets and current-driven DW inversion;

Fig. 2      schematically a Current-driven DW inverter;

Fig. 3      schematically reconfigurable NAND/NOR logic gates;

Fig. 4      schematically the electrical control of data flow and cascaded DW logic circuits;

Fig. 5      schematically a simple model of current-driven DW inversion in an OOP-IP-OOP structure;

Fig. 6      a micromagnetic simulation of DW inversion with a straight IP region;

Fig. 7      the DMI-OOP anisotropy phase diagram for current-driven DW inversion in a narrow wire;

Fig. 8      MOKE images of the time sequence of (a) the NAND gate and (b) the NOR gate used for the operational reliability measurements;

Fig. 9      schematically shows a proposal for MTJ/racetrack hybrid structure;

Fig. 10      various cascaded DW logic circuits;

Fig. 11      schematically examples for magnetic DW logic elements;

Fig. 12      the DW velocity in a uniform OOP region of a racetrack and effective DW velocity in a NOT gate as a function of current density;

Fig. 13      MOKE images of the time sequence of the NAND gate during operation and corresponding schematics;

Fig. 14      schematically illustrates the concept of a propagation delay time for the DW logic;

Fig. 15      Hall measurements of the logic operation in a NAND gate;

Fig. 16      schematically a device fabrication and magnetic characterization; and

Fig. 17      DW inversion in the DW inverter with a straight IP region.

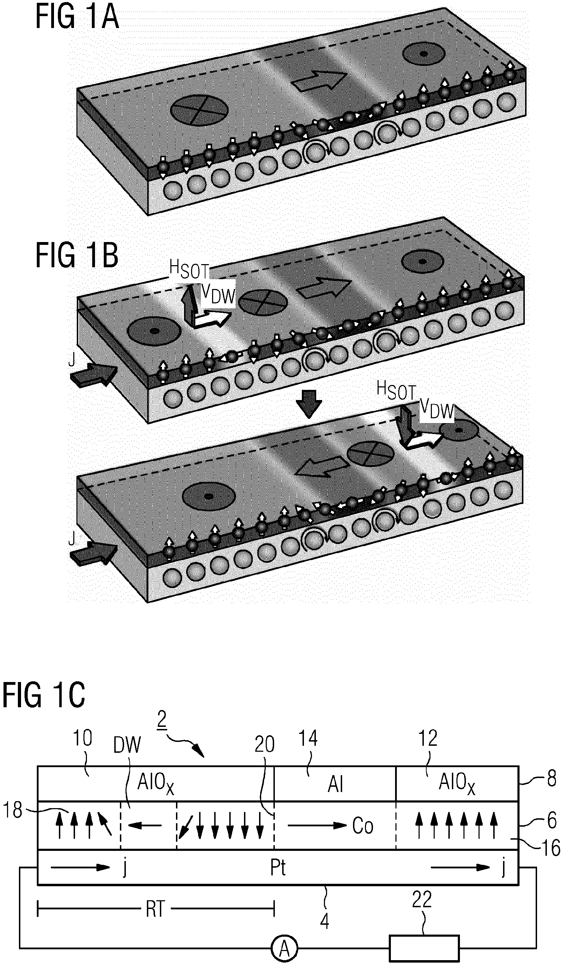

The present invention for chiral magnetic domain-wall (DW) logic for storing and/or processing data takes advantage of the efficiency and speed of magnetic DW motion induced by spin-orbit torques (SOTs) $H_{SOT}$ and exploits the chiral coupling between adjacent magnets with competing magnetic anisotropy and interfacial Dzyaloshinskii-Moriya interaction (DMI) (Fig. 1a). Based on this coupling, it is possible to invert a DW using an electric current, namely to transform an up/down ($\odot|\otimes$) DW into a down/up ($\otimes|\odot$) DW or vice versa. Here, the magnetization directions of $\otimes$ and

⊙ in the racetrack represent the Boolean logic "1" and "0", respectively.

In Fig. 1b, the design of a DW inverter is illustrated, which comprises an in-plane (IP) magnetized region embedded in a racetrack with out-of-plane (OOP) magnetization. As the two OOP regions on either side of the IP region are coupled by the DMI, the reversal of one OOP region induces the reversal of the other, leading to the inversion of a DW travelling along the racetrack which is equivalent to a NOT gate.

Fig. 1c shows schematically a cross-sectional view on a device 2 as described for Figures 1a and 1b. The device 2 comprises a support layer 4 of a conductive material, such as Pt. A ferro- or ferri-magnetic layer 6 (Co-layer) disposed on said support layer 4 being able to show the magnetic spin anisotropy and providing a magnetic racetrack RT. Further, a functional layer 8 is disposed on said ferro- or ferri-magnetic layer 6, said functional layer 8 in this example having a first metal-oxidic section 10 and a second metal-oxidic section 12 and a metallic section 14 between the first and the second metal-oxidic sections 10, 12 wherein the material of the functional layer allowing in its metal-oxidic form the ferro- or ferri-magnetic layer 6 to have a OOP magnetization perpendicular to the plain (OOP=out-of-plain) of the layers 4, 6, 8 and allowing in its metallic form the ferro- or ferri-magnetic layer 6 to have an IP magnetization parallel to the plain (IP=in-plane) of the layers only.

The OOP magnetization perpendicular and upwards oriented can thereby represent a logical "0" and downwards oriented a logical "1" or vice versa. Said Boolean logical "1" or a logical "0" can be coded in a second region 16 of the ferro- or ferri-magnetic layer 6 covered by the second metal-oxidic section 12 in response to moving the domain wall DW in a first region 18 of the ferro- or ferri-magnetic layer 6 being covered by the first metal-oxidic section 10 along the magnetic racetrack RT towards an interface 20 given at the transition of the first metal-oxidic section 10 to the metallic section 14 of the functional layer 8. A current supply 22 which provides a current density j to the support layer 4 is enabled to use controlled current pulses applied to the support layer 4 to cause the magnetic domain wall DW to determinable move along the magnetic racetrack RT back and forth.

In this embodiment, the magnetic spin anisotropy is achieved by the metal-oxidic layers and the metallic layer covering the ferro- or ferri-magnetic layer. Of course, there exist other possibilities to control the magnetic spin anisotropy, such as:

a) Ionic control anisotropy according to Aik Jun Tan et al., "Magneto-ionic control of magnetism using a solid-state proton pump", Nature Materials, Vol. 18, January 2019, 35 to 41, and Fanny Ummelen et al., "Racetrack memory based on in-plane-field controlled domain-wall pinning", Scientific reports, 7:833, DOI:10.1038/s41598-017-00837-x;

b) Electrical control of the ferromagnetic phase transition according to D. Chiba et al., "Electrical control of the ferromagnetic phase transition in cobalt at room temperature", Nature Materials, Vol. 10, November 2011, 853 to 856 and according to T. Maruyama et al., "Large voltage-induced magnetic anisotropy change in a few atomic layers of iron", Nature Nanotechnology Vol. 4, pages 158-161(2009);

c) Domain wall injection and pinning according to J.H.Franken et al., "Precise control of domain wall injection and pinning using helium and gallium focused ion beams, J.Appl.Phys. 109, 07D504 (2011).

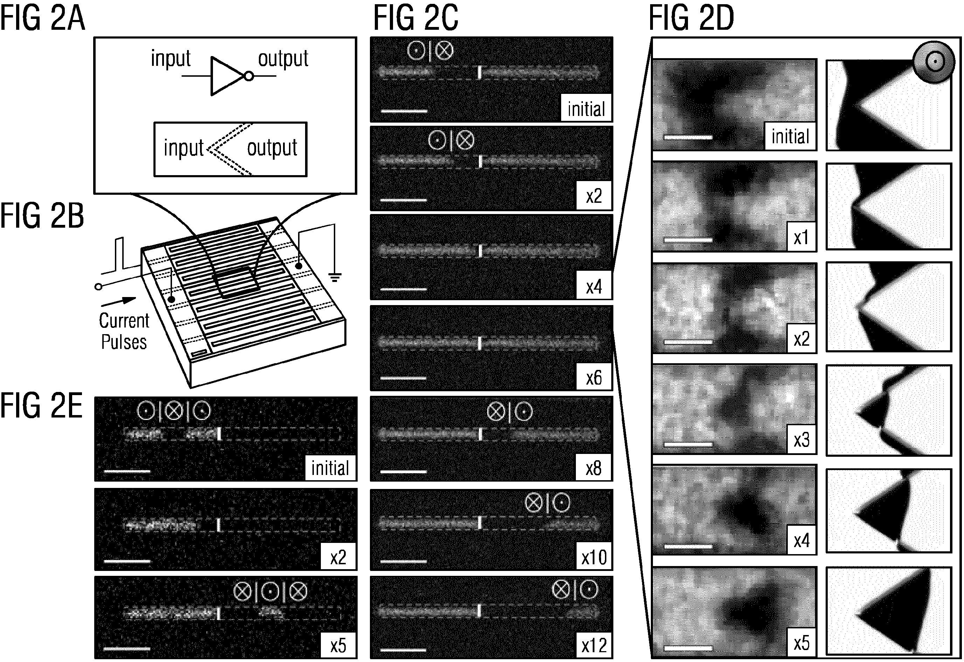

In order to demonstrate the operation of the DW inverter and as shown in Figure 2, a set of OOP magnetic nanowires of Pt/Co/AlO$_x$ with 50 nm-wide V-shaped IP regions patterned using a selective oxidation process (Fig. 2a) were fabricated. In this OOP magnetic nanowires, the Pt represents the support layer, Co the ferro-magnetic layer/magnetic racetrack and AlO$_x$ functional layer (AlO$_x$=metal-oxidic form).

The DW motion is driven by the electric current (Fig. 2b) and tracked with polar magneto-optic Kerr effect (MOKE) microscopy. Starting from the initial down-right-up magnetization configuration of the OOP-IP-OOP structure (⊗→⊙), an ⊙|⊗ DW is injected from the left OOP region (Fig. 2c).

By applying a sequence of current pulses, the ⊙|⊗ DW moves in the direction of the current towards the IP region (region covered by the metallic section of the functional layer), as expected for a left-handed chiral Néel DW. When the ⊙|⊗ DW encounters the IP region, the IP magnetization switches from → to ←, accompanied by the annihilation of the DW to the left of the IP region and nucleation of a new DW with opposite polarity to the right of the IP region. Insight into the microscopic mechanism of the DW inversion is provided by the combination of scanning transmission x-ray microscopy (STXM) and micromagnetic simulations (Fig. 2d). As the incident ⊙|⊗ DW approaches the IP region, it is compressed against the IP region by the spin-orbit torques SOTs and this in turn increases both the magnetostatic and exchange energies.

The resulting compact, high-energy spin texture can only be unwound by annihilating the incident DW and switching the IP magnetization with the help of SOTs. Upon switching of the IP magnetization from → to ←, a ⊗ domain nucleates on the right side of the IP region due to the chiral coupling. This process is promoted at the tip of the V-shaped inverter due to the additive contribution of chiral coupling from both sides of the V-shaped region. Therefore, the optimized design of the narrow V-shaped IP region (V-shaped metallic region 14) facilitates the switching of the IP magnetization and the nucleation of a new domain. As a result, the ⊙|⊗ DW is effectively transmitted through the IP region and transformed into a ⊗|⊙ DW.

An analogous inversion process occurs for an incident ⊗|☉ DW, so that the inverter effectively reverses the magnetization of domains travelling across the IP region, as shown in Fig. 2e. Not only is it possible to invert a single DW with an electric current, but also a sequence of DWs and, consequently, a sequence of domains that propagate along the magnetic racetrack RT. This is a unique feature of chirally coupled nanomagnetic structures.

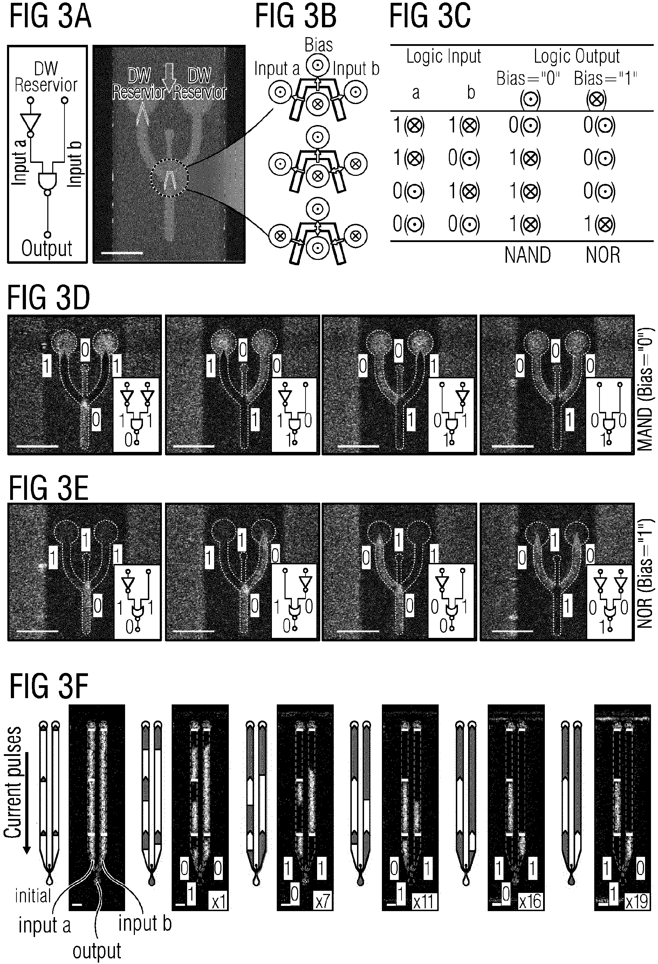

Building on the principles used to construct the NOT gate, it is demonstrated how to realize a reconfigurable NAND/NOR gate. This gate makes the concept for current-driven DW logic functionally complete, as any Boolean function can be implemented using a combination of NAND or NOR gates. The core structure of this gate (Fig. 3a) is composed of four OOP regions in the ferro-magnetic layer that form two logic inputs (Input a, Input b), one bias (Bias) and one logic output (Output) connected via IP regions (regions of the ferro- or ferrimagnetic layer covered with the metallic section 14 of the functional layer 8). With reference to the notation used for Figure 1c, the logical gate (NAND or NOR) comprises two magnetic racetracks RT representing the logical inputs of the logical gate. The magnetic racetracks RT are oriented substantially radially, preferably in a V- or Y-shape, in order to share a common second region 16 of the ferro- or ferri-magnetic layer 6 - said second region 16 thereby representing the logical output of the logical gate. In this area, they also share the second metal-oxidic section 12 of the functional layer 8 and the corresponding part of the support layer 4, wherein the first regions 18 of the two magnetic racetracks RT are separated by a magnetic bias region of determinable OOP magnetization. Of course, this magnetic bias region can also be designed as a magnetic racetrack RT, thus allowing the switching of the OOP orientation of the magnetization up- or downwards in the bias region. The metallic regions 14 of the functional layer 8 are accordingly arranged in a ring segment shaped form in alignment with the radial arrangement, preferably the V- or Y-shaped arrangement, of the two magnetic racetracks (RT).

To illustrate the functionality of the NAND gate, four devices were fabricated with the same core structure and different logic input configurations. For each device, two DW reservoirs are connected to the inputs via magnetic racetracks RT. The four logic input configurations of "11", "10", "01" and "00" are achieved by placing inverters after some of the DW reservoirs. The two DW reservoirs and the bias are set to logic "0" by applying an OOP magnetic field of 1 kOe. Applying current pulses, ⊗ (☉) magnetic domains propagate from the DW reservoirs with (without) inverters, defining the logic inputs to be "1" ("0"). As a result of the chiral coupling, the output magnetization depends on the relative alignments of the inputs and the bias (Fig. 3b and 3c), which is analogous to a majority gate. Therefore, for an ☉ bias, the output magnetization switches to ☉ only when both of the input magnetizations are ⊗. Otherwise, the output magnetization is ⊗.

As shown in the magnetic force microscopy (MFM) images (Fig. 3d), the magnetization direction of the logic output is ☉ ("0") for logic inputs of "11", and ⊗ ("1") for logic inputs of "10", "01" and "00". This relationship between the logic inputs and the output corresponds to the required logic operations for a NAND gate (Fig. 3c). By changing the orientation of the bias to ⊗, as shown in Fig. 3e, the NAND gate can be reconfigured into a NOR gate. In the latter case, the output magnetization is ⊗ only when both of the input magnetizations are ☉. Hence, the present logic gate can be reconfigured between NAND and NOR by switching the bias terminal, allowing for rapid logic reconfiguration during run time.

The operation of a single NAND gate is demonstrated using current-driven DW motion to provide a series of different logic inputs to the same gate over time (Fig. 3f). In this device, three DW inverters are placed in the lefthand racetrack and two DW inverters in the right-hand racetrack. This means that a sequence of current pulses will generate a sequence of logic inputs going from "00" to "11" to "01" to "11" to "10". The corresponding logic outputs will then change from "1" to "0" to "1" to "0" to "1", respectively, over time. For each operation, the DWs that give the two inputs may not arrive at the gate at the same time. This is mitigated by introducing a sufficient propagation delay time (see Methods). In a real device, this can be achieved by clocking the electric current. Furthermore, it would be possible to control the logic inputs and bias terminals with magnetic tunnel junctions (MTJs) fabricated on the magnetic racetracks, which can also be used for electrical read out of the outputs (see Methods).

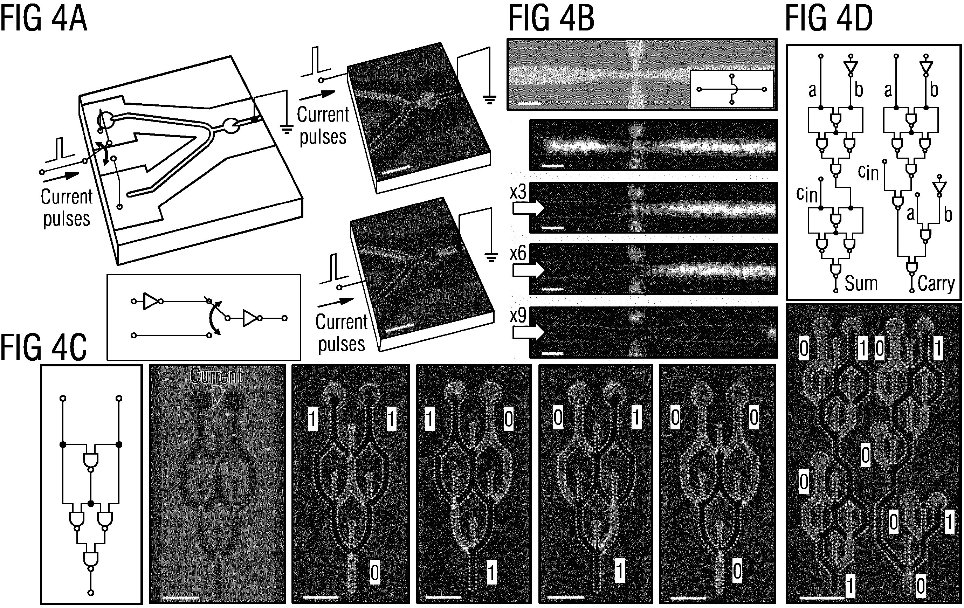

In addition to forming a complete logic set, chiral DW racetracks fulfil three additional requirements for practical implementation in logic circuits, namely input selectivity, data cross-over, and cascading of different logic gates. With the current-driven DW propagation through the Y-shape structure in Fig. 4a, it is possible to electrically select the logic input. A simple cross structure allows the DWs to propagate in orthogonal racetracks (Fig. 4b), which simplifies the design of cross-overs, avoiding the complexity of metal bridges used in conventional charge-based circuits.

Moreover, since the present logic inputs and outputs are based on the same physical phenomena, several logic gates can be directly cascaded without the need for additional transducers between magnetic and electric signals. As examples, in Fig. 4c a binary half adder is shown being created by cascading four NAND gates to form an XOR gate and further show the full adder operation by cascading 15 NAND gates in Fig. 4d. This circuit also demonstrates the possibility for fan-out of a single output that can be used to drive the input of the next logic gates.

Even the creation of magnetic logic circuits with feedback loops is possible. This is realized either using an external electrical circuit to read the output and write this back to the input with MTJs or using an additional racetrack with inverted current direction to drive DWs from the output back to the input.

For device applications, the scalability and efficiency of magnetic DW logic circuits can be addressed, too.

Because the chiral coupling induced by the DMI is effective at the scale of the magnetic moments, it is possible to scale the size of the logic gates down to a few nm using advanced lithography techniques. The speed of the logic operations is related to the DW velocity, which can reach several hundreds of m/s for chiral DWs driven by SOTs. The operation time can be estimated from the time required for a DW to transfer across the gate that, for an inverter scaled down to $10 \times 10$ nm$^2$, can be as fast as a few tens of ps (see Methods). The energy consumption of a single NOT operation in a $0.8 \times 1$ nm$^2$ racetracks is about 20 pJ, which would scale down to sub-20 aJ in structures with a $10 \times 10$ nm$^2$ footprint (see Methods).

The nonvolatility of the magnetic inputs and outputs gives further energy savings since magnetic DW logic circuits do not consume power when idle and do not need reloading of data after power-off. These features make all-electric magnetic DW logic attractive for use in low power, "instant-on" microelectronic processors that are ubiquitous in modern-day electronics.

The drawings are further commented in the following:

Figure 1 shows the Chiral coupling between adjacent nanomagnets and current-driven DW inversion. Figure 1a schematically shows the magnetic chiral coupling induced by DMI. After selective oxidization, the magnetization of neighbouring OOP (oxidized, dark grey shaded) and IP (unoxidized, light grey shaded) regions are aligned with a left-handed chirality in Pt/Co/AlO$_x$. Figure 1b schematically shows the current-driven DW inversion, which occurs as the DW transfers across the IP region. The white shaded region is the DW, and the direction of the effective field induced by the SOTs, $H_{SOT}$, and the DW velocity, $v_{DW}$, are indicated with arrows. In Pt/Co/AlO$_x$, both $\odot|\otimes$ and $\otimes|\odot$ DWs move in the same direction as the electric current $J$.

Figure 2 illustrates a Current-driven DW inverter. Figure 2a depicts schematically a NOT gate and a current-driven DW inverter. Dark grey and light grey shaded regions indicate regions with OOP and IP anisotropies, respectively. Figure 2b illustrates the SEM image of seven parallel DW inverters in a 3D rendering of the DW measurement setup. The direction of the current pulses is indicated. Figure 2c shows a MOKE image sequence of DW inversion for a DW incident from the left with an $\odot|\otimes$ configuration. The edges of the magnetic racetracks are indicated by dark grey dashed lines and the positions of the inverters are indicated by white lines. The bright and dark contrasts in the racetracks in the MOKE images correspond to $\odot$ and $\otimes$ magnetization, respectively.

Figure 2d shows the XMCD image sequence of DW inversion for an incident DW with an $\odot|\otimes$ configuration measured by STXM. Each image is captured after the application of one current pulse. The bright and dark contrasts in the XMCD images correspond to $\odot$ and $\otimes$ magnetization, respectively. Micromagnetic simulations of the inversion process are shown to the right of each image, with the directions of the magnetization indicated by the colour wheel.

Figure 2e depicts MOKE images showing the inversion of a $\otimes$ domain driven across the IP region with current pulses. The current density and duration of the pulses applied in Figures 2c and 2e are $7.5 \times 10^{11}$ A/m$^2$ and 50 ns, while for Figure 2d they are $1.1 \times 10^{12}$ A/m$^2$ and 1 ns. The scale bars are 3 $\mu$m in the MOKE images and 500 nm for the XMCD and simulation images.

Figure 3 schematically shows reconfigurable NAND/NOR logic gates. Figure 3a shows coloured SEM image of a reconfigurable NAND/NOR logic gate and corresponding logic circuit symbol. Different grey shades indicate regions in the logic gate with OOP and IP magnetic anisotropies, and the Pt strip, respectively. Figure 3b shows the schematics of the relationship between the magnetization in the two logic inputs, the bias, and the logic output for the NAND gate. Figure 3c is the truth table for the reconfigurable NAND and NOR logic operations. Figure 3d and 3e represent MFM images of different logic operations for inputs of "11", "10", "01" and "00" with a bias of "0" (d) and "1" (e), and their corresponding logic circuit symbol. The DW reservoirs (circular pads at the top of each image) and the bias are set to logic "0" by applying an OOP magnetic field of 1 kOe. Figure 3f shows MOKE image sequence and corresponding schematics showing the operation of a single NAND gate with a sequence of logic inputs driven by the electric current. The initial magnetization is set to be $\odot$ by applying an OOP magnetic field of 1 kOe. Light grey and dark grey in the schematic correspond to $\odot$ and $\otimes$ magnetization, respectively. The boundaries of the logic gate are indicated by dashed lines and the positions of the inverters are indicated by white lines. The direction and the number of current pulses applied before each MOKE image are indicated (current density $7.5 \times 10^{11}$ A/m$^2$ and pulse length 30 ns). The bright and dark contrast in the device regions in the MFM and MOKE images corresponds to $\odot$ and $\otimes$ magnetization, respectively. All the scale bars are 1 $\mu$m.

Figure 4 schematically shows the electrical control of the data flow and the cascaded DW logic circuits. Figure 4a illustrates a data flow switch through a Y-shaped structure. Left: Coloured SEM image of the device and corresponding logic circuit symbol. Right: MFM images of the magnetic configuration when current flows through the upper racetrack (top) and lower racetrack (bottom). Figure 4b represents a sequence of MOKE images illustrating electrical control of data flow through a cross structure. The direction and number of current pulses are indicated (current density $9 \times 10^{11}$ A/m$^2$ and pulse length 30 ns). An SEM image of the cross structure and the corresponding logic circuit symbol are shown at the top. Figure 4c schematically shows an XOR gate fabricated by cascading four NAND gates. Left: SEM image of the XOR logic gate and corresponding logic circuit symbol. Right: MFM images of the XOR logic gate with different logic inputs of "11", "10", "01" and "00". The DW reservoirs and the bias are set to logic "0" by applying an OOP magnetic field of 1 kOe. Different grey shades in the SEM images represent the regions with OOP and IP magnetization, and the Pt strips, respectively. Figure 4d) schematically shows a full adder gate. Top: logic circuit symbol of the full adder with input operands of "$a$ =0", "$b$ =1", and a carry bit of "$c_{in}$ =1". Bottom: MFM image of the full adder magnetic circuit. The bright and dark contrast in the device regions in the MOKE and MFM images correspond to ⊙ and ⊗ magnetization, respectively. All the scale bars are 1 μm.

**Methods**

A. Device fabrication

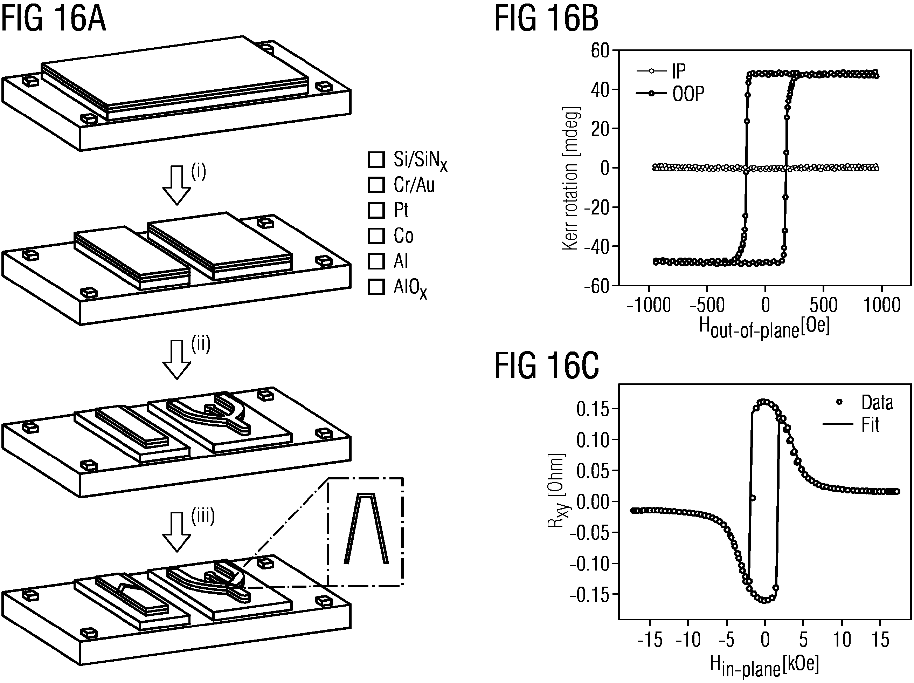

The magnetic films were deposited on a 200 nm-thick $SiN_x$ layer on a silicon substrate using dc magnetron sputtering at a base pressure < $2\times10^{-8}$ Torr and a deposition Ar pressure of 3 mTorr, and patterning was carried out by electron-beam lithography. Continuous films of Pt (5 nm)/Co (1.6 nm)/Al (2 nm) were milled into strips with Ar ions through a negative resist (ma-N2401) mask. In these magnetic strips, the upper Co/Al bilayer was milled through a high-resolution positive resist (PMMA) mask to create the DW racetracks and logic devices. In order to define the IP region in these magnetic structures, a second PMMA mask was patterned by electron-beam lithography on top of the Al layer. Using a low power (30 W) oxygen plasma at an oxygen pressure of 10 mTorr, the unprotected Al layer (regions 10 and 12 in Figure 1c) was oxidized to induce perpendicular magnetic anisotropy in the Co layer. Finally, electrodes of Cr (5 nm)/Au (50 nm) were fabricated using electron-beam lithography combining electron-beam evaporation with a lift-off process. The main steps of the device fabrication are shown in Figure 16a.
The different anisotropies, with OOP regions (exposed to oxygen plasma) and IP regions (protected with the PMMA mask), were confirmed with polar MOKE measurements (Fig. 16b). The effective OOP magnetic anisotropy field is 3.94 kOe obtained from anomalous Hall effect measurements with an applied IP magnetic field (Fig. 16c). The interfacial DMI constant $D$ was estimated to be -0.9±0.1 mJ/m$^2$ by measuring the DMI-induced chiral coupling.

B. Electrical measurement configuration

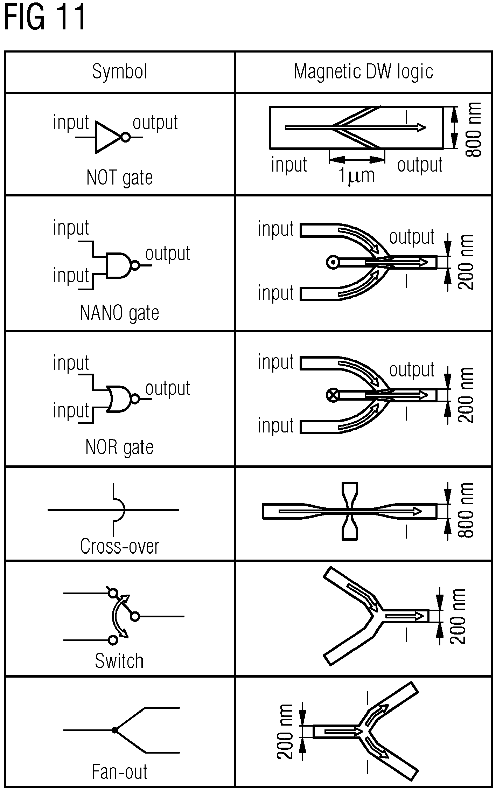

The magnetic DW motion and logic operation are driven by the current pulses generated with a HP Agilent 8114A high voltage pulse generator and AVTECH ultra-high speed pulse generator. The pulse generators can provide pulses of variable voltage and pulse width. The current densities are calculated by dividing the nominal voltage by the device resistance and cross sectional area, and are indicated for each operation. The directions of the current pulses are depicted for each device and summarized in Figure 11.

C. MFM measurements

The MFM measurements were performed using a Bruker Dimension Icon Scanning Station mounted on a vibration and sound isolation table using tips coated with CoCr. In order to minimize the influence of the stray field from the MFM tip during the measurements, a thin PMMA layer (~20 nm) was spin coated on the samples to increase the distance between the tip and the magnetic film.

D. MOKE microscopy measurements

The MOKE images were recorded using a custom-built wide-field MOKE microscope. The background image was captured after the application of a large positive OOP magnetic field of 1 kOe. The background image was subtracted from the subsequent images to achieve differential images with magnetic contrast. To prepare the initial state of the DWs shown in Fig. 2c, the racetrack was first saturated with an OOP magnetic field. The magnetic field was removed leaving the racetrack magnetized OOP, with a small reversed region at the V-shaped IP region resulting from the chiral coupling. Then current pulses were applied in the opposite direction to that shown in Fig. 2b in order to create a single DW on the left side of the DW inverter (Fig. 2c).

E. STXM measurements

The magnetic configuration of the DW inverter was imaged using scanning transmission x-ray microscopy at the PolLux beamline of the Swiss Light Source at Paul Scherrer Institute, 5232 Villigen PSI, Switzerland. The magnetization state was probed exploiting x-ray magnetic circular dichroism (XMCD) at the Co $L_3$ absorption edge at normal incidence. The devices measured using STXM were fabricated on x-ray transparent $SiN_x$ membranes.

F. Micromagnetic simulations

In order to understand the mechanism of the DW inversion, micromagnetic simulations were carried out with the MuMax[3] code using a computation box containing $2048 \times 1024 \times 1$ cells with a $2 \times 2 \times 1.6$ nm$^3$ discretization using the following magnetic parameters: saturation magnetization $M_S$ = 0.9 MA/m, effective OOP anisotropy field $H_{eff}$ = 150 mT, exchange constant $A$ = 16 pJ/m, spin Hall angle of Pt $\theta_{sh}$ = 0.1, and interfacial DMI constant $D$ = -1.5 mJ/m$^2$.

G. Mechanism for DW inversion

In order to elucidate the basic mechanism behind DW inversion in an OOP-IP-OOP structure, a simple model has been considered. The DW inversion process can be explained in terms of the effective DMI field generated in non-collinear magnets where the DMI vector lies in the plane of the magnetic thin film. This effective DMI field is given by:

$$\vec{H}_{\mathrm{DMI}} = \frac{2D}{\mu_0 M_{\mathrm{S}}} \left( \frac{\partial m_z}{\partial x}, 0, -\frac{\partial m_x}{\partial x} \right), \tag{1}$$

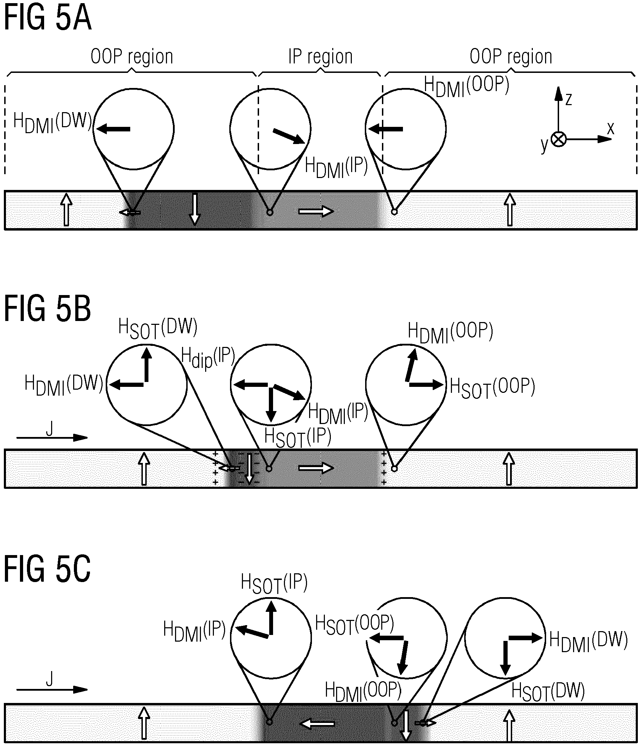

Then a situation can be considered where an $\odot|\otimes$ DW is driven by SOTs towards the IP magnetized region (see Fig. 5a). At equilibrium, the IP magnetized region together with the surrounding domains forms a $\otimes \rightarrow \odot$ configuration, which is stabilized by the DMI fields (pointing along +$x$) indicated by $H_{\mathrm{DMI}}$(IP). On applying an electric current, the magnetization is subject to an effective field $\boldsymbol{H}_{\mathrm{SOT}}$ induced by the SOTs, which is given by:

$$\vec{H}_{\mathrm{SOT}} = \frac{\hbar \theta_{\mathrm{SH}} J}{2\mu_0 e M_S t} \vec{m} \times \vec{\sigma}, \tag{2}$$

where $\hbar$, $\theta_{\mathrm{SH}}$, $J$, $e$, $M_s$, $t$, $\boldsymbol{m}$ and $\sigma$ are the Planck constant, spin Hall angle, electric current density, electron charge, saturation magnetization, thickness of magnetic layer, direction of magnetization and direction of spin polarization at the Pt/Co interface. Due to the chiral coupling, the magnetization in the middle of $\odot|\otimes$ DW points along -$x$.

As shown in Fig. 5b, the $\boldsymbol{H}_{\mathrm{SOT}}$(DW) points along +$z$ so that the $\odot|\otimes$ DW will propagate along the current direction. As soon as the $\odot|\otimes$ DW approaches the IP region, the magnetization in the IP region experiences a dipolar field $\boldsymbol{H}_{\mathrm{dip}}$ (IP) generated by the IP magnetization of the $\odot|\otimes$ DW that points along -$x$. The SOTs also compress the incident DW against the IP region and this in turn increases the DW energy. This results in a compact, high-energy spin texture containing two closely spaced regions with tail-to-tail IP magnetization as shown with the associated magnetic charges in Fig. 5b: one IP magnetization region is in the middle of the $\odot|\otimes$ DW with magnetization pointing along -x, and the other IP magnetization region is in the inverter and has magnetization pointing along +$x$.

At a certain point in time, the dipolar field becomes strong enough to switch the magnetization in the IP region from +$x$ to -$x$ with the help of SOTs (Fig. 5b and 5c). Simultaneously, the high-energy spin texture on the left side of the IP region collapses, bringing about the annihilation of the $\otimes$ domain on the left hand side of the IP region shown in grey in Fig. 5b. After the reversal of the magnetization in the IP region, a reverse $\otimes$ domain is nucleated on the right side of the IP region (shown in grey in Fig. 5c) as a consequence of the $\boldsymbol{H}_{\mathrm{DMI}}$ (OOP) pointing along -$z$. The magnetization points along +$x$ in the middle of the resulting $\otimes|\odot$ DW and the $\boldsymbol{H}_{\mathrm{SOT}}$ (DW) points along -$z$ so that this new DW is then transported by the electric current towards +$x$ (Fig. 5c).

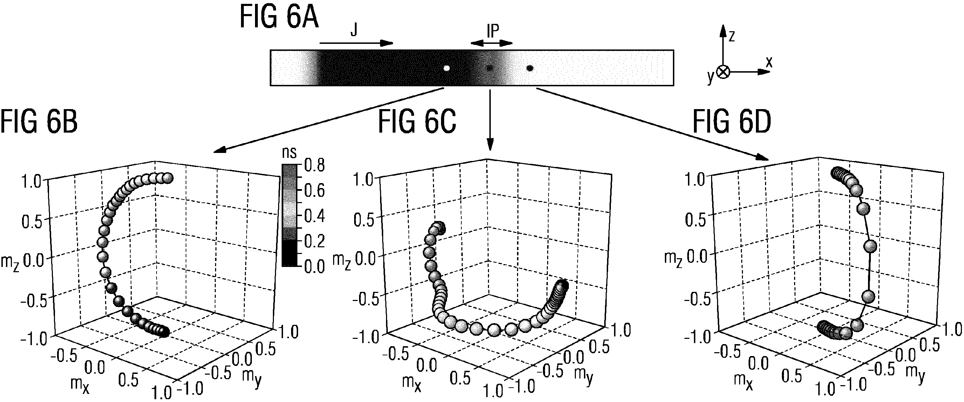

While this simple model provides insight into the mechanism for DW inversion, the detailed magnetization dynamics is more complex. Therefore, micromagnetic simulations have been performed accordingly. Here, an $\odot|\otimes$ DW is driven by an electric current with current density $3 \times 10^{12}$ A/m$^2$ in a narrow wire containing a straight, 30 nm - wide IP region (Fig. 6a). The OOP anisotropy field was set to $H_k$= 1.5 kOe in the OOP region and set to zero in the IP region. All three components of the magnetization were recorded at three different positions along the wire: in the center of the IP region, and 30 nm away from the center on each side (see the dots in Fig. 6a).

In Fig. 6b to 6d it is shown how the magnetization responds to the approaching DW. As the $\odot|\otimes$ DW approaches the left side of the IP region, the magnetization on the left side of the IP region reverses from -$z$ to +$z$ (see Fig. 6b). The magnetization in the IP region reverses from +$x$ to -$x$ along the path shown in Fig. 6c to reduce the energy associated with the accumulated magnetostatic charges (shown schematically in Fig. 6c). The magnetization on the right side of the IP region is then forced to switch from +$z$ to -$z$ by the chiral coupling (see Fig. 6d).

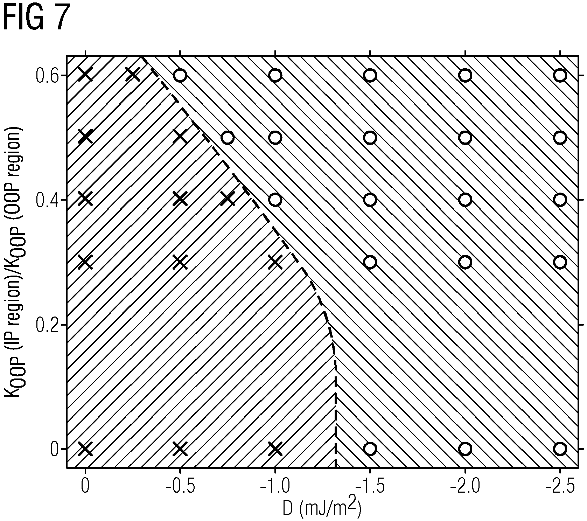

The DMI is critical in the realisation of current-driven DW inversion, not only to achieve current-driven DW motion, but also due to its role in the nucleation of the reverse domain. The role of DMI in the DW inversion process is determined with micromagnetic simulations by varying the DMI value and the OOP anisotropy in the IP region. The DMI-OOP anisotropy phase diagram for current-driven DW inversion is shown in Fig. 7 for a current density of $3\times10^{12}$ A/m$^2$ in a narrow wire containing a straight, 30 nm - wide IP region. For zero OOP anisotropy in the IP region, the DW can be inverted when $D < -1$ mJ/m$^2$. If the DMI is reduced, it does not provide sufficient chiral coupling to nucleate the reverse domain, so that the incident DW cannot be inverted.

By introducing OOP anisotropy into the IP region, which is expected from a Pt/Co interface, the energy for the DW inversion is reduced and the DMI operational window increases.

In order to verify the impact of the IP width on the DW inversion process, additional micromagnetic simulations of the magnetization dynamics in the inverter for various widths of the IP region have been performed. The outcomes of the simulations for a current density of $3\times10^{12}$ A/m$^2$ and $D$= -1.5 mJ/m$^2$ are given in Table 1.

**Table 1 | Outcome of the simulation of the DW inverter for $J$= $3\times10^{12}$ A/m$^2$ and $D$ = -1.5 mJ/m$^2$.**

| IP width/nm | 10 | 20 | 25 | 30 | 35 | 40 | 50 |
|---|---|---|---|---|---|---|---|
| $K_{OOP}$ (IP region)= 0 | ✗ | ✗ | ✓ | ✓ | ✓ | ✗ | ✗ |
| $K_{OOP}$ (IP region)/ $K_{OOP}$ (OOPregion) = 0.3 | ✓ | ✓ | ✓ | ✓ | ✓ | ✓ | ✗ |

The anisotropy $K_{OOP}$ (IP region) and $K_{OOP}$ (OOP region) denote the uniaxial OOP anisotropy in the IP region and in the OOP region, respectively. The tick (cross) indicates that an inverted DW can (cannot) propagate from the IP region into the OOP region.

Here a tick indicates that an inverted DW propagates from the IP region into the OOP region as required. If the IP region is too narrow (<25 nm), the OOP regions on either side of the inverter are strongly antiparallel coupled and the SOTs induced by the current are not strong enough to overcome the chiral coupling.

If the width of the IP region is too large (>35 nm), the chiral coupling becomes too weak to give an antiparallel coupling of the OOP magnetizations on the left and right sides of the IP magnetization. The DW is then simply annihilated in the IP region without any further magnetization dynamics occurring on the other side of the inverter.

The results of the micromagnetic simulations were confirmed by experiment: for a straight DW inverter in an 800 nm-wide racetrack, the DW was successfully transferred across a 50 nm-wide DW inverter but not across a 100 nm-wide inverter. As shown in Table 1, it is possible to increase the operational window of the IP region by including a small OOP anisotropy in the IP region.

H. Influence of the shape of the IP region of the DW inverter

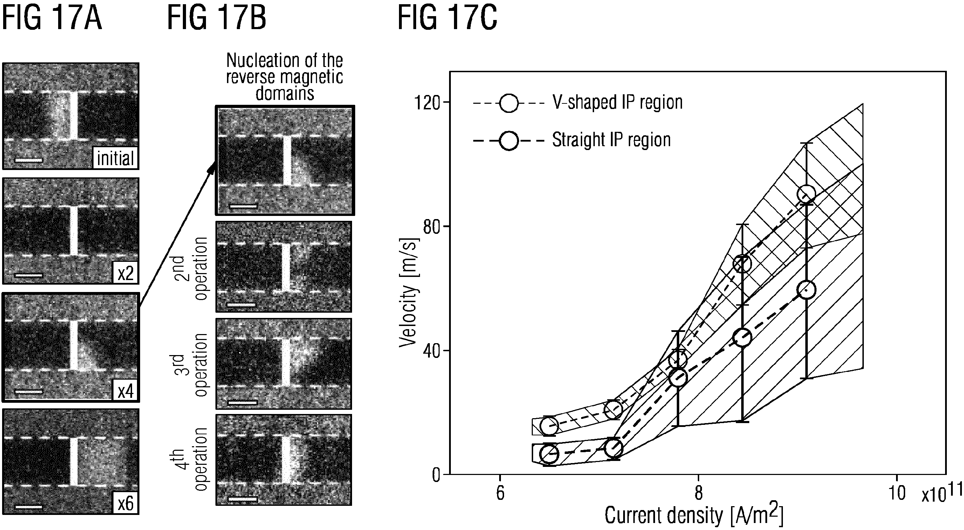

Here the performance of straight and V-shaped DW inverters are experimentally compared where the width of the IP region is 50 nm, beginning with the measurements of the straight IP inverter. As shown in the STXM images in Fig. 17a, when the ⊗|⊙ DW encounters the IP region, the DW will annihilate to the left of the IP region and a new DW with opposite polarity will be nucleated to the right of the IP region. Several inversion operations were performed in the same inverter with a straight IP region and found that the reverse magnetic domains nucleate at different locations (Fig. 17b). This implies that the nucleation of the reverse magnetic domain is assisted by the random thermal fluctuations or local inhomogeneities.

To improve the reliability of the DW inverter, a V-shaped IP region has been implemented, which has two main advantages: Firstly, the tip of the V-shape offers an easy nucleation site for the reversed magnetic domain. This is because, at the tip of the V shape, the output OOP region is surrounded by the input OOP region, and experiences the strongest antiparallel chiral coupling. In the STXM measurements, it was found that the nucleation of the reversed magnetic domain is located at the tip of the V-shape for five out of five operations. Secondly, the V-shape of the IP region leads to lower magnetostatic energy, so lowering the energy barrier for DW inversion. As shown in Fig. 17c, the effective DW velocity measured in DW inverters with a V-shaped and straight IP regions was measured (see the method outlined in estimation of the speed of logic operation in Methods). The velocity of the DW transferring across the IP region in the V-shaped IP inverter is higher than that of the DW in straight IP inverter and the standard deviation of the velocity is smaller in the V-shaped IP inverter compared to that of the straight IP inverter. This demonstrates the higher efficiency and reliability of the V-shaped IP region as a DW inverter.

I. Estimation of the speed of logic operation

Here, the speed of a logic operation in the NOT gates has been investigated. First, the DW velocity, $v_{DW}$, in the uniform OOP region of the racetracks is measured. Then, the DW displacement, $L_{DW}$, is determined from $S_1$ to $S_2$

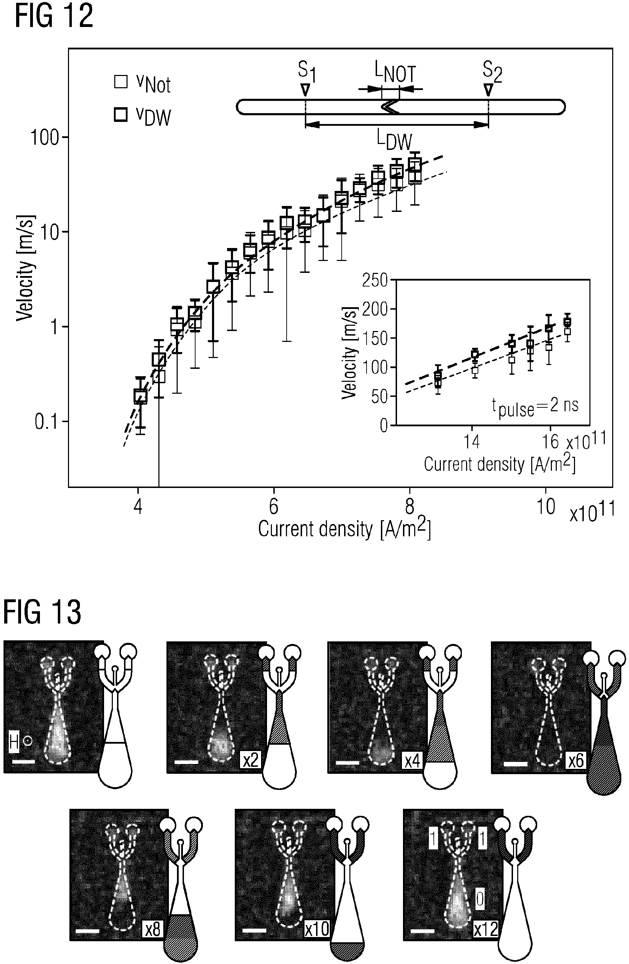

across the NOT gate following $N$ current pulses (see schematic in Fig. 12). From this, the time taken by the DW to transfer across the NOT gate, $t_{NOT}$, has been taken and therefore the effective velocity of the DW, $v_{NOT}$, as it transfers across the NOT gate and is inverted:

$$t_{NOT} = Nt_{pulse} - \frac{L_{DW} - L_{NOT}}{v_{DW}}; \quad v_{NOT} = \frac{L_{NOT}}{t_{NOT}}, \qquad\qquad (3)$$

where $t_{pulse}$ and $L_{NOT}$ are the length of current pulse and length of the NOT gate, respectively. With this method, we can determine $v_{DW}$ and $v_{NOT}$ as a function of current density (Fig. 12). The pulse length was decreased to 2 ns for high current densities to reduce heating, with the data given in the inset in Fig. 12. It was found that the velocity of the DW in the NOT gate can reach 160117 m/s for a current density of $1.65 \times 10^{12}$ A/m$^2$. This value of the DW velocity is used to estimate the energy consumption.

Here, the time for the DW to transfer across the DW inverter is estimated with the dimensions indicated in Fig. 11 scaled down to $10 \times 10$ nm$^2$. Taking the effective inverter DW velocity determined from the experiment of 160 m/s, the time for a DW to transfer across the downscaled inverter is $\approx 60$ ps. For a more accurate estimation, micromagnetic simulations for the downscaled inverter with dimensions $10 \times 10$ nm$^2$ were performed. At such a small scale, the device design is limited by the feature size that can be nanofabricated. Therefore, a straight IP region is considered instead of a V-shaped one, with a width of 10 nm. Taking the simulated effective inverter DW velocity of 118 m/s, the time for a DW to transfer across the inverter is 85 ps, which is similar to the rough estimation above. The speed of operation can be further improved by the optimization of the material to increase the DW velocity, e.g., by using an amorphous magnetic material such as CoFeB instead of Co, and device design.

Using a similar method for the DW inverter, then the speed of a logic operation was estimated in the NAND gate from experiment. For this, the operation of the NAND gate with two DW inverters in the input reservoirs was captured using MOKE imaging. Following the application of current pulses, DWs propagate through the NAND gate and perform logic operations (see MOKE images and corresponding schematics in Fig. 13). From these images, the time for the DW to transfer across the NAND gate is determined to be $t_{NAND} = 74.1$ ns with an effective DW velocity of $v_{NAND} = 10.8$ m/s at a current density of $7.5 \times 10^{11}$ A/m$^2$.

J. Synchronization and propagation delay times in the DW circuits

Due to the presence of defects that lead to pinning of the DWs and the intrinsic stochastic nature of current-driven DW motion, the arrival time of DWs at the logic gates can be different. In electronic logic circuits, this is commonly addressed by introducing a propagation delay time for each operation, i.e., the circuits are cycled at a rate that is slower than the longest internal propagation delay times. The same concept of propagation delay time can be applied to the present magnetic DW logic gates so that a stable output can be obtained that is independent of the arrival time of the input domains. In other words, with sufficient propagation delay time, all the DWs will arrive at the logic gate, which will result in the correct output for a given logic operation.

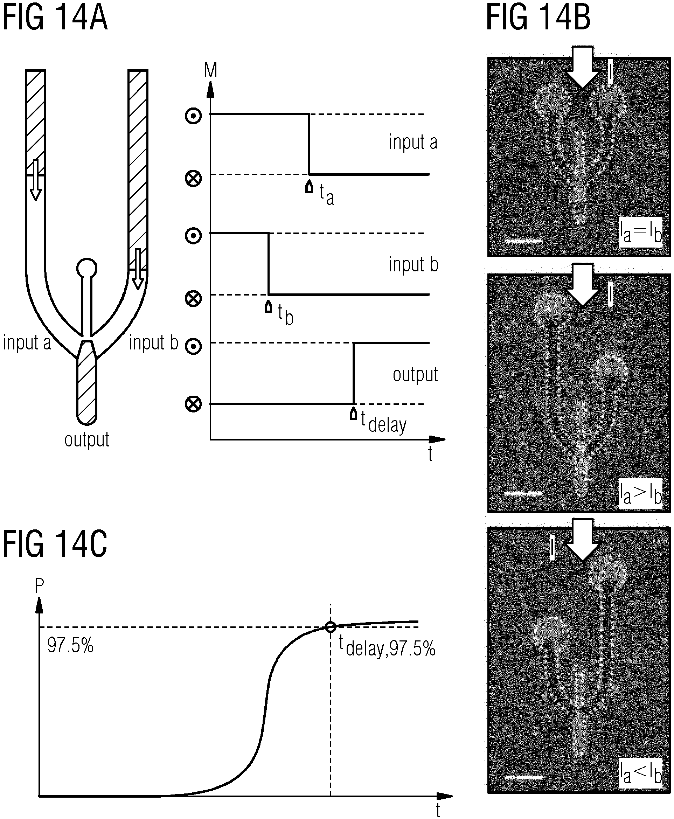

To demonstrate how the introduction of a propagation delay time can improve the gate operational reliability, the simplest case of a NAND gate has been considered with the logic inputs changing from "00" to "11" over time. As schematically shown in Fig. 14a, the arrival times of $\otimes|\odot$ DWs for logic inputs $a$ and $b$ are different. In this case, the change from "0" to "1" of input $a$ is slower than that for input $b$, i.e., $t_a > t_b$, where $t_i$ ($i = a, b$) is the time at which the inputs change.

Once both DWs arrive at the gate, it will take some time for the nucleation of the reverse magnetic domain, which depends on the effective DW velocity in the NAND gate. The time after the correct magnetic domain propagates into the output racetrack is defined as the required propagation delay time $t_{delay}$. NAND gates with "11" logic inputs were fabricated with different input racetrack lengths to give different arrival times of the two logic inputs. On application of current pulses, a $\otimes|\odot$ DW propagates in both the left and the right input racetracks. This is the most critical configuration to test for the propagation delay time reliability of the logic gate. As shown in Fig. 14b, all devices give the correct output "0", demonstrating that the output of the magnetic DW logic gate is independent of the difference in the arrival time of the input DWs.

For all logic operations in the NAND gate, in general, the operation includes (i) DW propagation in the input racetracks, (ii) DWs transfer across the logic gate and (iii) DW propagation in the output racetrack. The total operation time, and therefore the required propagation delay time, can then be expressed as:

$$t_{delay} = \frac{L_{input} + L_{output}}{v_{DW}} + \frac{L_{NAND}}{v_{NAND}} , \qquad (5)$$

where $L_{input}$, $L_{out}$, and $L_{NAND}$ are the length of input racetrack, output racetrack and NAND gate, respectively. $v_{DW}$ and $v_{NAND}$ are the DW velocities in the magnetic racetrack and NAND gate, respectively. Assuming that the DW velocities in the magnetic racetrack and NAND gate have a normal distribution:

$$v_{DW} \sim N(\overline{v}_{DW}, \sigma_{DW}{}^2)$$
$$v_{NAND} \sim N(\overline{v}_{NAND}, \sigma_{NAND}{}^2) , \qquad (6)$$

where $\overline{v}_{DW}$ ($\overline{v}_{NAND}$) and $\sigma_{DW}$ ($\sigma_{NAND}$) represent the average and standard deviation of the velocity distribution of DW motion in a magnetic racetrack (NAND gate). To obtain a 97.5% probability that the logic operation is successful (see Fig. 14c), the required propagation delay time can be estimated to be

$$t_{delay,97.5\%} = \frac{L_{input} + L_{output}}{\overline{v}_{DW} - 2\sigma_{DW}} + \frac{L_{NAND}}{\overline{v}_{NAND} - 2\sigma_{NAND}} . \qquad (7)$$

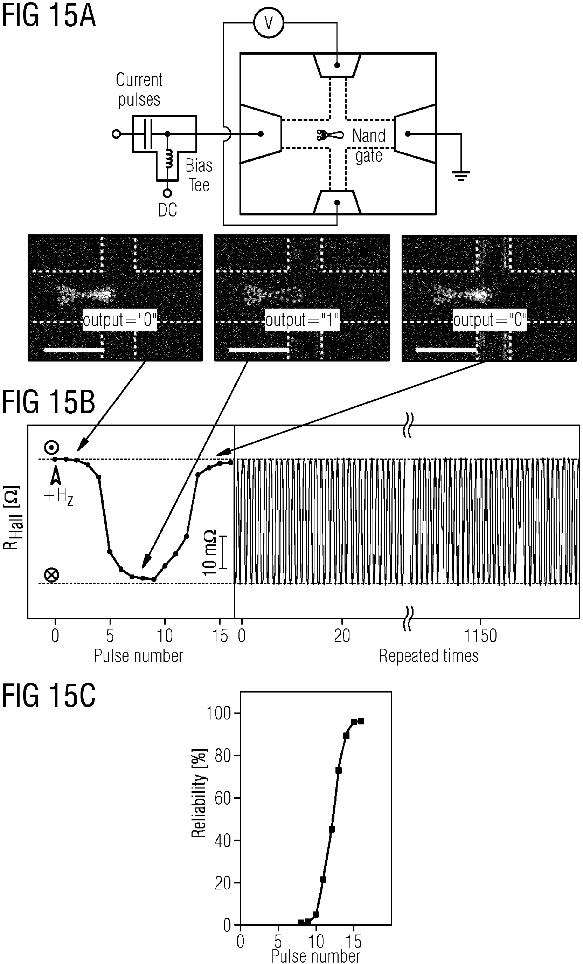

To demonstrate that a sufficient propagation delay time can improve the reliability for a statistically significant number of operations in a NAND gate, the output of a NAND gate was placed on a Hall cross (Fig. 15a) and 1172 measurements were performed. For each measurement, the NAND gate is saturated with an OOP magnetic field to set the initial magnetization direction to $\odot$ in all of the reservoirs and a series of current pulses are applied. The output is measured via the anomalous Hall effect on application of a DC current. The pulse source and DC source are separated by a bias tee.

As indicated by the change of the Hall resistance in Fig. 15b, the output changes from "0" to "1" and back to the state of "0". The electrical measurements are verified with MOKE measurements performed on the NAND gate (see MOKE images in Fig. 15b). By using 14 current pulses (equivalent to a propagation delay time of $14 \times 30$ ns), the reliability of the NAND gate increases to >95% (Fig. 15c) .

For a cascaded logic circuit, the propagation delay time is determined by the longest DW propagation route in the circuit. In order to decrease the propagation delay time, several possible approaches, e.g., scaling of the dimensions of the circuit, increase of the DW velocity and decrease of pinning, can be employed.

K. Reliability of the logic gates

In order to realize large-scale implementation of the logic gates, reliable operation is essential. Here, the reliability of the two basic NOT and NAND gates were evaluated in terms of device-to-device reliability and operational reliability (Table 2).

**Table 2 | Reliability of the NOT and reconfigurable NAND gates.**

| Logic gate | Reliability | |
|---|---|---|
| | Device-to-device reliability* | Operational reliability† |
| NOT gate | 34/35 | 25/25 |
| NAND gate | 42/56 | 20/20 |

*Device-to-device reliability is the number of functional devices that give correct outputs/the total number of devices.
†Operational reliability is the number of successful operations for a single device/the total number of operations performed.

To demonstrate the high device-to-device reliability of the NOT gate, 35 NOT gates and 34 were fabricated of them (97%) showed successful operation. The NOT operations have been also performed with various current densities in the range $4 \times 10^{11}$ A/m$^2$ to $1.65 \times 10^{12}$ A/m$^2$ in a single device with 100 % operational reliability.

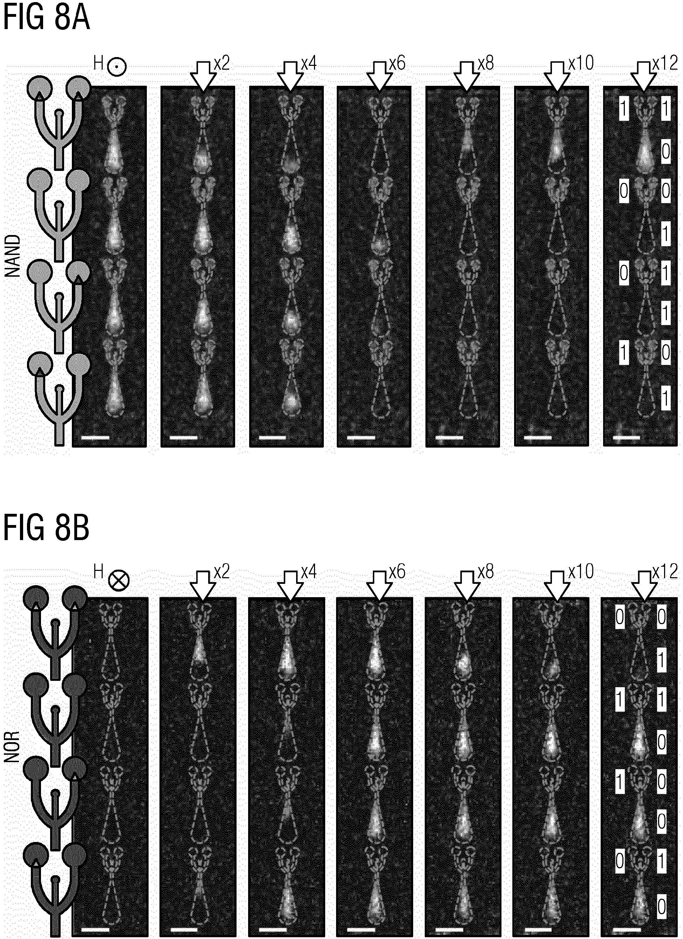

To test the device-to-device reliability of the NAND gate, 56 NAND gates with different logic inputs were fabricated and the average success rate was found to be 42/56 (75%). The failure of some of the devices may be related to pinning of the DWs by defects in the material or irregular features resulting from the nanofabrication. The width of the magnetic racetracks in the NAND gate is 200 nm compared to 800 nm for the NOT gate, which means that the edge roughness can induce more pinning. For four selected devices, 20 operations were performed for each device (Fig. 8) and they all gave correct outputs, showing high operational reliability.

The distribution of the device-to-device reliability for different logic inputs has been further considered. For the 56 NAND gates, 14 of each type were fabricated with logic inputs "00", "11", "01" and "10". The number of NAND gates that give correct outputs/the total number of NAND gates are 13/14, 11/14, 10/14 and 8/14 for logic inputs of "00", "11", "01" and "10", respectively. The device-to-device reliabilities for "00" and "11" inputs are slightly higher than those of "01" and "10" inputs. This can be understood by considering the energy difference between the "1" and "0" outputs for "00", "11", "01" and "10" inputs given by:

$$\Delta E_{1/0}{}^{00} = -(2E_{\text{input}} + E_{\text{bias}})$$

$$\Delta E_{1/0}{}^{11} = 2E_{\text{input}} - E_{\text{bias}}$$

$$\Delta E_{1/0}{}^{01} = -E_{\text{bias}}$$

$$\Delta E_{1/0}{}^{10} = -E_{\text{bias}} \qquad , \qquad\qquad (8)$$

where $\Delta E_{1/0}{}^{ij}$ is the energy difference between the "1" and "0" outputs for input "$ij$" ("$ij$"= "11", "00", "01" or "10"), $E_{\text{input}}$ is the coupling strength between output and input, and $E_{\text{bias}}$ is the coupling strength between the output and the bias, respectively. From this set of equations, it follows that the stable output for the "11" input is "0" ($\Delta E_{1/0} > 0$) and the stable outputs for the other inputs of "00", "01" and "10" are "1" ($\Delta E_{1/0} < 0$), which satisfies the truth table of the NAND operation.

For the NAND gate used in the experiment, the size of bias is a bit smaller than that of the inputs. Since the energy of coupling between two OOP magnetizations separated by the IP region is proportional to the length of their boundary, the coupling energy between the output and input magnetization is larger than the coupling energy between the output and bias magnetization, i.e., $E_{\text{input}} > E_{\text{bias}}$. Hence, $|\Delta E^{00}| > |\Delta E^{11}| > |\Delta E^{01}| = |\Delta E^{10}|$ for the NAND operation. This trend in the energy difference between the correct and erroneous outputs for different logic inputs correlates well with the trend in the device-to-device reliability for different logic inputs.

The operational reliability of the cascaded logic circuit (full adder) shown in Fig. 4d was also tested. The number of successful operations/the total number of operations performed was found to be 28/30.

Therefore, in the present proof-of-concept experiments, a high reliability of the magnetic gates has been demonstrated. It has to be further emphasized that there is plenty of room to improve the device-to-device reliability in terms of optimization of the fabrication process, device design, and material properties.

L. Electrical control of logic inputs and detection of logic output

For the proof-of-concept experiment shown in Fig. 3f, it was ensured that specific DWs reached the inputs by placing inverters on the input racetracks. After saturation with an OOP magnetic field, the magnetization direction in the racetrack was set to ⊙. On application of a current, the magnetization of the propagating DWs was reversed as they were transferred across each inverter. By placing different numbers of inverters at different positions in the input racetracks, a sequence of logic inputs was generated in order to obtain different inputs at the same gate over time and, in this way, its real-time operation is demonstrated. It was also shown that electrical switching of DW propagation in a Y-shape structure could be used to inject DWs and define specific logic inputs (Fig. 4a).

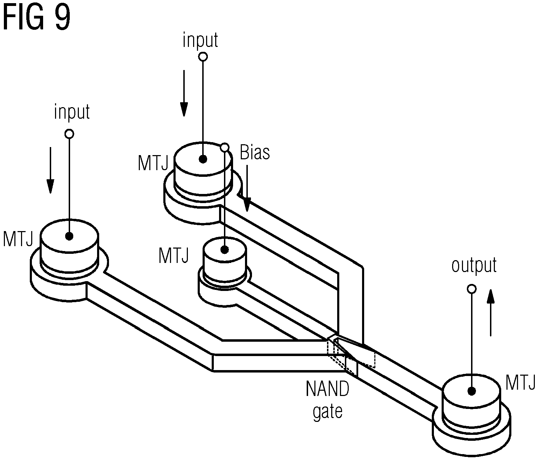

For downscaled logic circuits, magnetic tunneling junctions (MTJs) fabricated on the logic input racetracks would provide a more compact method to control the logic inputs (Fig. 9). Indeed, it has been shown that an MTJ on a magnetic racetrack can be used to write magnetic domains via spin transfer torque (STT). Therefore, MTJs fabricated on magnetic racetracks can be used to electrically control the logic inputs. For the detection of the logic outputs, MFM, MOKE microscopy and Hall measurements were used in our proof-of-concept experiment. For the downscaled logic circuits, MTJs fabricated on the output racetracks could be used to electrically detect the logic outputs.

Moreover, it is practical to not only be able to read the output of a gate and but also to transfer this to the input of another gate using MTJ devices in order to realize information feedback. The feedback is critical for sequential logic operations such as those performed in a flip-flop gate. Therefore, the MTJ/racetrack hybrid structure can provide a compact method to perform complex logic, too.

L. Energy consumption of downscaled logic devices

For the estimation of energy consumption of the inverter used in the experiments, the area containing the V-shaped IP region is considered where the DW is reversed. The energy consumption per operation of the inverter is calculated from the power-delay product in the bottom Pt layer:

$$E = I^2 Rt = \frac{J^2 \rho W L^2 h}{v_{\text{NOT}}} , \qquad\qquad (9)$$

where $J, \rho, W, L, h,$ and $v_{\text{NOT}}$ represent the current density, resistivity of Pt, inverter width, inverter length, thickness of Pt layer (5 nm) and effective DW velocity in the inverter, respectively. Taking the inverter dimensions of $W \times L = 0.8 \times 1.0$ $\mu m^2$, Pt resistivity in a thin film of $\rho = 30.0$ $\mu\Omega \cdot cm$, and the current density and effective inverter DW velocity measured experimentally of $J = 1.65 \times 10^{12}$ A/m$^2$ and $v_{\text{NOT}} = 160$ m/s, the energy consumption per operation of the inverter is calculated from Eq. 9 to be 20.4 pJ.

For a rough estimation of the energy consumption of a downscaled inverter, the dimensions of the inverter have been down-scaled while keeping the value of the Pt layer thickness, the Pt resistivity, the current density and the effective DW velocity across the inverter the same as those measured in the experiment. The energy consumption per operation for an inverter with the dimensions indicated in Fig. 11 scaled down to $10 \times 10$ nm$^2$ is 25.5 aJ. For a more accurate estimation, micromagnetic simulations were performed for a downscaled inverter with lateral dimensions of $10 \times 10$ nm$^2$. At such a small scale, the device design is limited by the feature size that can be nanofabricated. Therefore, a straight IP region is considered instead of a V-shaped one, with a width of 10 nm. Using a simulated current density of $1.2 \times 10^{12}$ A/m$^2$ and effective inverter DW velocity of 118 m/s in Eq. 9, it was found that the energy consumption per operation is 18.4 aJ, which is similar to the rough estimation above.

This energy consumption for the downscaled inverter is comparable to the switching energy of $\approx 30$ aJ found in advanced CMOS devices. Further improvement of the energy consumption can be achieved by optimizing the material and device design in order to decrease the required current density and increase the DW velocity.

The above estimation concerns only the energy consumed in the logic gate, i.e. the energy consumed for the inversion of a DW. There is additional energy required to nucleate the DWs in the racetrack for the logic inputs, to detect the logic outputs and to move DWs along the interconnections. The total energy consumption therefore depends on the detailed design of the logic circuit.

In the following the remaining drawings are described in more detail:

Figure 5 schematically shows a simple model of current-driven DW inversion in an OOP-IP-OOP structure. Figure 5a to c show the side view of the DW transfer across an inverter. The magnetization direction in the racetracks and the directions of the effective fields $H_{\text{DMI}}$, $H_{\text{SOT}}$, and $H_{\text{dip}}$ are indicated by arrows in the different regions. The magnetic charges associated with the compact high-energy spin texture is shown in b.

Figure 6 shows a micromagnetic simulation of DW inversion with a straight IP region. Figure 6 represents the device geometry used in the micromagnetic simulations. The positions at which the three components of the magnetization are recorded are indicated with dots. Figure 6b to d show the time evolution of the magnetization at the three points (b) to the left side of IP region, (c) in the middle of IP region and (d) to the right side of IP region as they are indicated in Figure 6a.

Figure 7 shows the DMI-OOP anisotropy phase diagram for current-driven DW inversion in a narrow wire containing a straight, 30 nm - wide IP region with a current density of $3 \times 10^{12}$ A/m$^2$. The light grey circles and the dark grey crosses indicate that the DW is or is not inverted for specific DMI and anisotropies in the simulations. The relevant regions in the phase diagram are highlighted with dark grey and light grey shading. Here the anisotropies KOOP(IP region) and KOOP(OOP region) denote the uniaxial OOP anisotropy in the IP region and in the OOP region, respectively.

Figure 8 shows MOKE images of the time sequence of (a) the NAND gate and (b) the NOR gate used for the operational reliability measurements. The corresponding schematics of the different inverter configurations are shown to the left. The DW reservoirs and the bias are set with an applied OOP magnetic field to (a) "0" for the NAND operation and (b) "1" for the NOR operation, respectively. Light grey and dark grey in the schematic correspond to $\odot$ and $\otimes$ magnetization, respectively. The V-shaped inverters at the DW reservoirs are associated with small reverse domains in the initial state (indicated as dark grey or light grey triangles) resulting from the chiral coupling. The boundaries of the NAND/NOR gate are indicated by dashed lines. The sequence of the MOKE images are captured where each image is taken after two current pulses with current density of $7.5 \times 10^{11}$ A/m$^2$ and pulse length of 30 ns. In the MOKE images, the bright and dark contrasts in the gate structure correspond to $\odot$ and $\otimes$ magnetization, respectively. All the scale bars are 1 $\mu m$.

Figure 9 schematically shows a proposal for MTJ/racetrack hybrid structure for the electrical control of the logic inputs and detection of the logic output in a downscaled magnetic DW logic device. Dark grey and light grey shaded regions indicate regions with OOP and IP magnetizations, respectively. Three MTJs located on the reservoirs of the logic inputs and bias are used to control their magnetization and one MTJ on the output racetrack is used to detect the output magnetization. The directions of applied current are indicated with arrows.

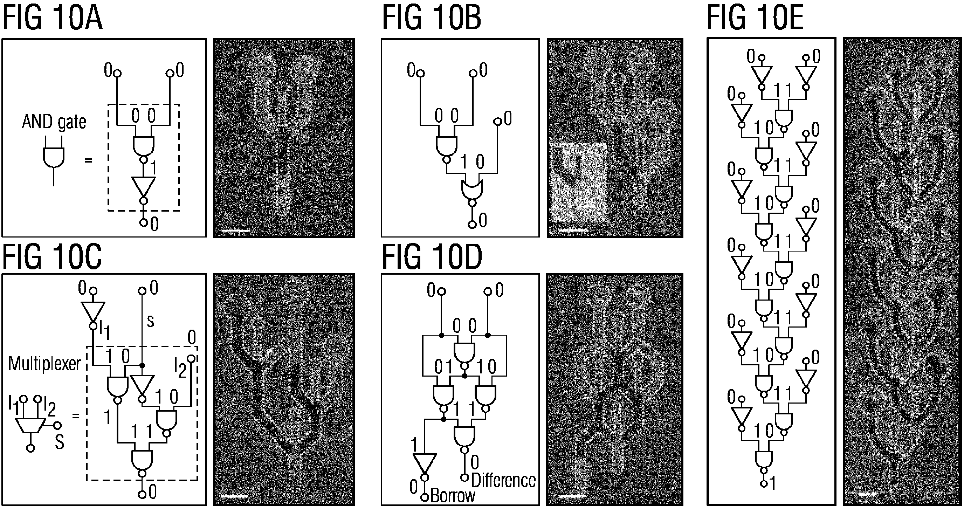

Figure 10 shows various cascaded DW logic circuits. Figure 10a represents an AND gate fabricated by cascading one NAND gate and one NOT gate. Figure 10b shows a cascaded DW logic circuit with NAND gate and NOR gate. Note that there is an inverter placed in the bias reservoir for the NOR gate highlighted with the green box giving a bias of "1" as shown in inset, while the bias for the NAND gate is "0". Figure 10c is a two-bit multiplexer fabricated by cascading three NAND gates and one NOT gate. Figure 10d shows a half subtractor fabricated by cascading four NAND gates and one NOT gate. Figure 10e represents a long cascaded DW logic circuits including 10 NAND gates and 11 NOT gates. The bright and dark contrasts in the device regions in the MFM images correspond to $\odot$ and $\otimes$ magnetization, respectively. The MFM images are captured after saturation with an OOP magnetic field to set the initial magnetization direction to $\odot$ in all of the reservoirs followed by applied current pulses to get the final states. All the scale bars are 500 nm.

Figure 11 shows schematically examples for magnetic DW logic elements. Differently grey shaded regions indicate regions with OOP and IP anisotropy, respectively. The direction of current flow is indicated by black arrows. The dimensions of the magnetic DW logic elements used in the experiments are indicated.

Figure 12 depicts the DW velocity in a uniform OOP region of a racetrack and effective DW velocity in a NOT gate as a function of current density. Error bars represent the standard deviation of the DW velocity measured in 5 different devices.

Figure 13 represents MOKE images of the time sequence of the NAND gate during operation and corresponding schematics. The NAND gate contains two inverters in the DW reservoirs and a bias set to "0", and the boundaries of the NAND gate are indicated by dashed lines. The two V-shaped inverters in the DW reservoirs are associated with small reverse domains in the initial state (indicated as purple triangles) resulting from the chiral coupling. A sequence of MOKE images is captured where each image is taken following two current pulses with a current density of $7.5 \times 10^{11}$ A/m$^2$ and a pulse length of 30 ns. The bright and dark contrasts in the gate structure in the MOKE images correspond to $\odot$ and $\otimes$ magnetization, respectively. The two DW reservoirs and the bias are set to logic "0" by applying an OOP magnetic field of 1 kOe. All the scale bars are 1 $\mu$m.

Figure 14 schematically illustrates the concept of a propagation delay time for the DW logic. Figure 14a represents schematically the use of the propagation delay time to improve the operational reliability of the logic operation in a NAND gate. The different grey shades correspond to $\odot$ and $\otimes$ magnetization, respectively. Figure 14b shows the MFM images of the NAND gates with different input racetrack lengths (top: $l_a = l_b$, middle: $l_a > l_b$, bottom: $l_a < l_b$, where $l_a$ and $l_b$ represent the racetrack length of input $a$ and $b$, respectively). The bright and dark contrasts correspond to $\odot$ and $\otimes$ magnetization, respectively. The MFM images are captured after saturation with an OOP magnetic field to set the initial magnetization direction to $\odot$ in all of the reservoirs followed by application of current pulses to obtain the final states. The direction of the current flow is indicated. Figure 14c schematically shows the dependence of the probability of giving a correct output as a function of propagation delay time. All the scale bars in the MFM images are 500 nm.

Figure 15 shows Hall measurements of the logic operation in a NAND gate. In Figure 15a, different grey shades in the optical image of the device represent the regions with electrodes, the Pt cross and the NAND gate, respectively. Figure 15b shows the Hall resistance as a function of the pulse number and the corresponding MOKE images. Left: typical Hall resistance evolution with increasing number of pulses. Right: the first 30 measurements and last 30 measurements of the 1172 repeated measurements. The Hall resistance levels for $\odot$ and $\otimes$ output magnetizations are indicated by the dashed lines. An OOP magnetic field is applied to set the initial state at the beginning of each measurement indicated with the red arrow. The bright and dark contrast in the gate structure in the MOKE images correspond to $\odot$ and $\otimes$ magnetization, respectively. The boundaries of the NAND gate are indicated by dashed lines. The current density and pulse length of the applied current pulses are $7.5 \times 10^{11}$ A/m$^2$ and 30 ns, respectively. Figure 15c represents the operational reliability of the logical NAND gate as a function of the number of current pulses. All the scale bars are 2 $\mu$m.

Figure 16 shows the device fabrication and magnetic characterization. Figure 16a shows the schematics of main nanofabrication processes for magnetic DW logic circuits. (i) Ion milling of magnetic Pt/Co/Al multilayer to create magnetic strips, (ii) ion milling to produce magnetic racetracks and logic gates, and (iii) oxidization of the Al layer in the OOP regions. In the inset, an SEM image is shown of the 50-nm wide PMMA mask used to protect the IP region of the NAND gate shown in Fig. 3a during oxygen plasma treatment. The scale bar in the SEM image is 100 nm. Figure 16b represents a polar MOKE measurement of IP and OOP regions on application of an OOP magnetic field. Finally Figure 16c represents the anomalous Hall measurement of OOP region on application of an IP magnetic field.

Figure 17 shows an DW inversion in the DW inverter with a straight IP region. Figure 17a represents an STXM image sequence of DW inversion for an incident $\otimes|\odot$ DW performed in the DW inverter with a straight IP region. Each XMCD image is captured after the application of two current pulses. The edges of the magnetic racetracks are indicated with red dashed lines and the positions of the inverters are indicated with solid white lines. The bright and dark contrast in the XMCD images correspond to $\odot$ and $\otimes$ magnetization, respectively. The current density and duration of the pulses are $1.1 \times 10^{12}$ A/m$^2$ and 1 ns. Figure 17b shows STXM images of the nucleation of reverse magnetic domains in the same DW inverter with a straight IP region for four different operations. Figure 17c shows the DW velocity in the DW inverters with a V-shaped and straight IP regions as a function of current density determined from the experimental MOKE measurements. Error bars for each point and colored shading represent the standard deviation of the DW velocity for 5 measurements. All the scale bars are 500 nm.

## Claims

1. Device (2) for storing and/or processing data using the concept of magnetic domain wall motion induced by spin-orbit torques,
   said device comprising:

   a) a support layer (4) of a conductive material;
   b) a ferro- or ferri-magnetic layer (6) disposed on said support layer (4) being able to show tunable magnetic anisotropy and providing a magnetic racetrack (RT);
   c) a functional layer (8) in terms of the tunable magnetic anisotropy disposed on said ferro- or ferri-magnetic layer (6), said functional layer (8) having a first functional section (10) and a second functional section (12) and a third functional section (14) between the first and the second functional section (10, 12), wherein the first and the second sections of the functional layer (8) allowing the ferro- or ferri-magnetic layer (6) to have an OOP magnetization perpendicular to the plane of the layers (4, 6, 8) and the third section of the functional layer allowing the ferro- or ferri-magnetic layer (6) to have an IP magnetization parallel to the plane of the layers (4, 6, 8) only; wherein:

   d) an OOP magnetization perpendicular and upwards oriented represents a logical "0" and downwards oriented a logical "1" or vice versa or an IP magnetization in one direction represents a logical "0" and in the other direction a logical "1" or vice versa;
   e) said logical "1" or a logical "0" can be coded in a second region (16) of the ferro- or ferri-magnetic layer (6) covered by the second section (12) or in the third region of the ferro- or ferri-magnetic layer (6) in response to moving a domain wall (DW) in a first region (18) of the ferro- or ferri-magnetic layer (6) being covered by the first section (10) along the magnetic racetrack (RT) towards the interface (20) given at the transition of the first section (10) to the third section (14) and vice versa; and
   f) a current supply (22) to the support layer (4) wherein controlled current pulses applied to the support layer (4) causing the magnetic domain wall (DW) to determinably move along the magnetic racetrack (RT).

2. The device (2) according to claim 1, wherein the functionality of the first and second section of the functional layer is achieved by at least one of:

   a) the functional layer of the first and the second section is metal-oxidic layer, while the third section is a metallic layer;
   b) the third section is an insulator layer comprising an electrode enabling the application of an electrical field over the ferro- or ferrimagnetic layer in the OOP direction;
   c) the third section of the functional layer are metal-oxidic layer being penetrated by a solid-state proton pump; and/or
   d) the third section of the functional layer are metal-oxidic layer being penetrated by helium and/or gallium focused ion beams.

3. The device (2) according to claim 1 or 2, wherein the conductive material is selected from a group consisting of: Platinum; W, Ta, Ir, Pd, Ru, WOx, WNx, TaN, CuBi, PtxCu1-x, PtxAu1-x, Bi2Se3, Bi2SbxTe1-x.

4. The device (2) according to any of the preceding claims, wherein the ferro- or ferri-magnetic layer (6) comprises a metallic composition selected from a group consisting of: Iron, Cobalt, Nickel and their alloys, CoFeB, Co/Ni multilayers, GdFeCo, GdCo, GdFe, GdCoFe, TbCo.

5. The device (2) according to any of the preceding claims, wherein the functional layer (8) comprises a metallic composition selected from a group consisting of: Aluminum, Tantalum, Gadolinium, Magnesium, Ruthenium, Hafnium.

6. The device (2) according to any of the preceding claims,

wherein the support layer (4) and/or the ferro- or ferri-magnetic layer (6) and/or the functional layer (8) have a length in the range from 10 nm to 100 $\mu$m and/or a width in the range from 10 nm to 10 $\mu$m and/or a height in the range from 0.5 nm to 10$\mu$m.

7. Logical gate comprising a number of devices (2) according to any of the preceding claims, wherein two magnetic racetracks (RT) representing the logical inputs of the logical gate are substantially radially, preferably in a V- or Y-shape, disposed in order to share a common second region (16) of the ferro- or ferri-magnetic layer - said second region thereby representing the logical output of the logical gate - and to share the second functional section, preferably the metal-oxidic section (12), of the functional layer (8), wherein the first regions (18) of the two magnetic racetracks (RT) are separated by a magnetic bias region (Bias) of determinable magnetization and wherein the third regions (14) of the functional layers (8) are arranged in a ring segment shaped form in alignment with the radial arrangement, preferably the V- or Y-shaped arrangement, of the two magnetic racetracks (RT).

8. Logical gate according to claim 7, wherein the two racetracks (RT) have a different input racetrack length to give different arrival times of the two logic inputs.

9. Logical gate according to claim 7 or 8, wherein the metallic region (14) of the functional layer (8) has a V-shaped form, having the peak of the V showing into the direction of the magnetic racetrack (RT) and vice.

## FIG 1A

## FIG 1B

$H_{SOT}$
$V_{DW}$

J

$H_{SOT}$ $V_{DW}$

J

## FIG 1C

2

10   DW        20   14        12

AlO$_X$              Al        AlO$_X$        8

18                                            6
↑↑↑↗ ← ↙↓↓↓↓↓↓ → Co    ↑↑↑↑↑↑    16

j        Pt              j

RT        4    22

(A)

FIG 2A

input ▷○ output

input ◁ output

FIG 2B

Current
Pulses

FIG 2E

FIG 2C

FIG 2D

EP 3 876 234 A1

# FIG 3A

# FIG 3B

# FIG 3C

| Logic Input | | Logic Output | |
|---|---|---|---|
| | | Bias="0" | Bias="1" |
| a | b | (⊙) | (⊗) |
| 1(⊗) | 1(⊗) | 0(⊙) | 0(⊙) |
| 1(⊗) | 0(⊙) | 1(⊗) | 0(⊙) |
| 0(⊙) | 1(⊗) | 1(⊗) | 0(⊙) |
| 0(⊙) | 0(⊙) | 1(⊗) | 1(⊗) |
| | | NAND | NOR |

# FIG 3D

# FIG 3E

# FIG 3F

FIG 4A

FIG 4B

FIG 4C

FIG 4D

FIG 5A

FIG 5B

FIG 5C

FIG 6A

FIG 6B

FIG 6C

FIG 6D

FIG 7

## FIG 8A

## FIG 8B

FIG 9

input

input

MTJ

Bias

MTJ

MTJ

output

NAND
gate

MTJ

FIG 10A

AND gate

FIG 10B

FIG 10C

Multiplexer

FIG 10D

Difference

Borrow

FIG 10E

# FIG 11

| Symbol | Magnetic DW logic |
|---|---|
| input ▷○ output<br><br>NOT gate | <br>input ⟶1 μm⟵ output  800 nm |
| input<br>input ⟶ output<br><br>NANO gate | <br>input / input / output  200 nm |
| input<br>input ⟶ output<br><br>NOR gate | <br>input / input / output  200 nm |
| Cross-over |  800 nm |
| Switch |  200 nm |
| Fan-out | 200 nm  |

## FIG 12

## FIG 13

# FIG 14A

input a

input b

output

M

input a

$\overset{\blacktriangle}{\square}\, t_a$

input b

$\overset{\blacktriangle}{\square}\, t_b$

output

$\overset{\blacktriangle}{\square}\, t_{delay}$

t

# FIG 14B

I

$I_a = I_b$

I

$I_a > I_b$

I

$I_a < I_b$

# FIG 14C

P

97.5%

$t_{delay, 97.5\%}$

t

**FIG 15A**

**FIG 15B**

**FIG 15C**

FIG 16A

FIG 16B

FIG 16C

FIG 17A

FIG 17B

Nucleation of the reverse magnetic domains

FIG 17C

EP 3 876 234 A1

Europäisches Patentamt

European Patent Office

Office européen des brevets

## EUROPEAN SEARCH REPORT

Application Number

EP 20 16 1352

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | ZHAOCHU LUO ET AL: "Chirally coupled nanomagnets", SCIENCE, vol. 363, no. 6434, 29 March 2019 (2019-03-29), pages 1435-1439, XP055735066, ISSN: 0036-8075, DOI: 10.1126/science.aau7913 * page 1438, right-hand column, paragraph 2 - page 1439, middle column, paragraph 1; figures 1, 3F, 4 * | 1-9 | INV. G11C11/16 G11C19/08 |
| A | BAOSHAN CUI ET AL: "Field-free perpendicular magnetization switching through domain wall motion in Pt/Co/Cr racetracks by spin orbit torques with the assistance of accompanying Joule heating effect", ARXIV.ORG, CORNELL UNIVERSITY LIBRARY, 201 OLIN LIBRARY CORNELL UNIVERSITY ITHACA, NY 14853, 13 September 2017 (2017-09-13), XP081293899, DOI: 10.1039/C7CP08352A * page 2, paragraph 1 - page 12, paragraph 2 * | 1-9 | |

-/--

TECHNICAL FIELDS SEARCHED (IPC)

G11C
H03K

The present search report has been drawn up for all claims

| Place of search | Date of completion of the search | Examiner |
|---|---|---|
| The Hague | 1 October 2020 | Colling, Pierre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 20 16 1352

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | T. PHUONG DAO ET AL: "Chiral Domain Wall Injector Driven by Spin-Orbit Torques", NANO LETTERS, vol. 19, no. 9, 16 August 2019 (2019-08-16), pages 5930-5937, XP055735097, US ISSN: 1530-6984, DOI: 10.1021/acs.nanolett.9b01504 * page 5930, right-hand column, paragraph 2 - page 5931, right-hand column, paragraph 3; figures 1,4 * * page 5934, left-hand column, last paragraph - page 5935, right-hand column, paragraph 1 * ----- | 1-9 | |

TECHNICAL FIELDS
SEARCHED (IPC)

The present search report has been drawn up for all claims

| Place of search | Date of completion of the search | Examiner |
|---|---|---|
| The Hague | 1 October 2020 | Colling, Pierre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **ZHAOCHU LUO et al.** Chirally coupled nanomagnets. *Science,* 2019, vol. 363, 1435-1439
- **AIK JUN TAN et al.** Magneto-ionic control of magnetism using a solid-state proton pump. *Nature Materials,* January 2019, vol. 18, 35-41
- **FANNY UMMELEN et al.** Racetrack memory based on in-plane-field controlled domain-wall pinning. *Scientific reports,* vol. 7, 833
- **D. CHIBA et al.** Electrical control of the ferromagnetic phase transition in cobalt at room temperature. *Nature Materials,* November 2011, vol. 10, 853-856
- **T. MARUYAMA et al.** Large voltage-induced magnetic anisotropy change in a few atomic layers of iron. *Nature Nanotechnology,* 2009, vol. 4, 158-161
- **J.H.FRANKEN et al.** Precise control of domain wall injection and pinning using helium and gallium focused ion beams. *J.Appl.Phys.,* 2011, vol. 109, 07D504